# EUROPEAN PATENT APPLICATION

(11) **EP 4 657 601 A1**
(43) Date of publication of application: **03.12.2025**
(21) Application number: 24915569.8
(22) Date of filing: 19.12.2024
(51) Int. Cl.: H01M 10/42, H01M 10/04, H01M 50/105, G01R 27/02

(54) **JIG FOR PRESSURIZING POUCH-TYPE SECONDARY BATTERY AND METHOD FOR INSPECTING POUCH-TYPE SECONDARY BATTERY USING SAME**

(30) Priority: 04.01.2024 KR 20240001279
(71) Applicant: LG Energy Solution, Ltd., Seoul 07335 (KR)
(72) Inventor: LEE, Dong Wook, Daejeon 34122 (KR); CHO, Kyung Min, Daejeon 34122 (KR)
(74) Representative: Goddar, Heinz J.
(86) International application number: PCT/KR2024/020683
(87) International publication number: WO 2025/146987

(57) **Abstract**

Disclosed are a pouch-shaped secondary battery pressing jig including a first pressing unit including a first pressing plate configured to seat a second surface of a pouch-shaped secondary battery thereon, a second pressing unit including a second pressing plate having an air hole configured to allow a fifth surface and a sixth surface to communicate with each other, the second pressing unit being configured to press a first surface of the pouch-shaped secondary battery, and an air injection unit configured to inject air to the first surface of the pouch-shaped secondary battery through the air hole and a pouch-shaped secondary battery inspection method using the same.

## Description

### [Technical Field]

This application claims the benefit of priority to Korean Patent Application No. 2024-0001279 filed on January 4, 2024, the disclosure of which is incorporated herein by reference in its entirety.

The present invention relates to a pouch-shaped secondary battery pressing jig and a pouch-shaped secondary battery inspection method using the same, and more particularly to a pouch-shaped secondary battery pressing jig capable of determining whether a pouch-shaped secondary battery is defective by pressing both surfaces of the pouch-shaped secondary battery and measuring the insulation resistance of the pouch-shaped secondary battery and a pouch-shaped secondary battery inspection method using the same.

### [Background Art]

With technological development of mobile devices and an increase in demand therefor, secondary batteries, which are capable of being charged and discharged, have been used as an energy source for various mobile devices. Secondary batteries have also attracted attention as an energy source for electric vehicles and hybrid electric vehicles presented as alternatives to existing gasoline and diesel vehicles, which use fossil fuels.

Depending on the shape of a battery case, secondary batteries are categorized into a cylindrical battery having an electrode assembly mounted in a cylindrical metal can, a prismatic battery having an electrode assembly mounted in a prismatic metal can, and a pouch-shaped battery having an electrode assembly mounted in a pouch-shaped case made of an aluminum laminate sheet.

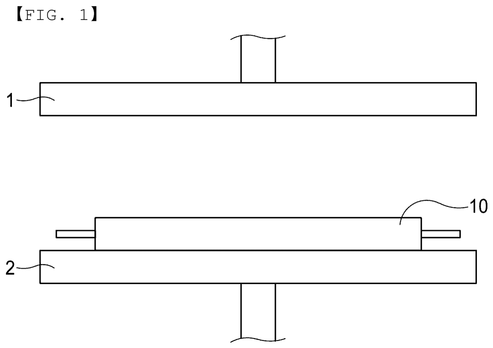

FIG. 1 is a view illustrating a conventional pouch-shaped secondary battery pressing jig.

Referring to FIG. 1, a pouch-shaped secondary battery 10 is seated on an upper surface of a lower jig 2, an upper jig 1 is moved downward to press the pouch-shaped secondary battery 10, and a measurement unit measures the insulation resistance between the pouch-shaped secondary battery 10 and the upper jig 1 or the lower jig 2, thereby determining whether the pouch-shaped secondary battery is defective.

In the conventional pouch-shaped secondary battery pressing jig, the surface pressure is generated between the pouch-shaped secondary battery 10 and the lower jig 2 when the pouch-shaped secondary battery 10 is pressed, whereby the pouch-shaped secondary battery 10 is moved in a state of being attached to a lower surface of the upper jig 1 when the upper jig 1 is moved upward, which causes pickup errors.

### (Prior Art Document)

(Patent Document 1) Korean Patent Application Publication No. 2015-0054372

### [Disclosure]

### [Technical Problem]

The present invention has been made in view of the above problems, and it is an object of the present invention to provide a pouch-shaped secondary battery pressing jig capable of determining whether a pouch-shaped secondary battery is defective while preventing the occurrence of the surface pressure of the pouch-shaped secondary battery after pressing the pouch-shaped secondary battery and a pouch-shaped secondary battery inspection method using the same.

### [Technical Solution]

As a technical means for achieving the above object, a pouch-shaped secondary battery pressing jig according to an embodiment of the present invention includes a first pressing unit (100) including a first pressing plate (110) configured to seat a second surface (12) of a pouch-shaped secondary battery (10) thereon, a second pressing unit (200) including a second pressing plate (210) having an air hole (213) configured to allow a fifth surface (211) and a sixth surface (212) to communicate with each other, the second pressing unit being configured to press a first surface (11) of the pouch-shaped secondary battery (10), and an air injection unit (300) configured to inject air to the first surface (11) of the pouch-shaped secondary battery (10) through the air hole (213).

Also, in the pouch-shaped secondary battery pressing jig according to the embodiment of the present invention, the first pressing unit (100) may include the first pressing plate (110) including a third surface (111) in contact with the second surface (12) of the pouch-shaped secondary battery (10) and a first driving unit (120) having a shaft (121) connected to a fourth surface (112) of the first pressing plate (110) and configured to support the first pressing plate (110), the first driving unit being configured to move the first pressing plate (110) in a first direction.

Also, in the pouch-shaped secondary battery pressing jig according to the embodiment of the present invention, the first pressing unit (100) may further include a pressing sensor (130) configured to measure force applied in a second direction when the force applied in the second direction is transmitted to the pouch-shaped secondary battery (10) by the second pressing unit (200).

Also, in the pouch-shaped secondary battery pressing jig according to the embodiment of the present invention, the first driving unit (120) may be configured to apply force in the first direction to the second surface (12) of the pouch-shaped secondary battery (10) in response to the force applied in the second direction measured by the pressing sensor (130).

Also, in the pouch-shaped secondary battery pressing jig according to the embodiment of the present invention, the second pressing unit (200) may include the second pressing plate (210) in contact with the first surface (11) of the pouch-shaped secondary battery (10) and a second driving unit (220) having a shaft (221) connected to the fifth surface (211) of the second pressing plate (210), the second driving unit being configured to move the second pressing plate (210) in the second direction.

Also, in the pouch-shaped secondary battery pressing jig according to the embodiment of the present invention, the second driving unit (220) may be configured to move the second pressing plate (210) in the second direction and may provide the force applied in the second direction to the first surface (11) of the pouch-shaped secondary battery (10).

Also, in the pouch-shaped secondary battery pressing jig according to the embodiment of the present invention, the second pressing plate (210) may be disposed spaced apart from the first pressing plate (110) in the first direction.

Also, in the pouch-shaped secondary battery pressing jig according to the embodiment of the present invention, the air hole (213) may be a plurality of air holes in a central part of the second pressing plate (210) in contact with the first surface (11) of the pouch-shaped secondary battery (10).

Also, in the pouch-shaped secondary battery pressing jig according to the embodiment of the present invention, when the first surface (11) of the pouch-shaped secondary battery (10) is attached to the second pressing plate (210), the air injection unit (300) may be configured to inject air to the first surface (11) of the pouch-shaped secondary battery (10) to separate the pouch-shaped secondary battery (10) from the second pressing plate (210).

Also, the pouch-shaped secondary battery pressing jig according to the embodiment of the present invention may further include a measurement unit (400) configured to measure the insulation resistance between the pouch-shaped secondary battery (10) and the first pressing plate (110) or the second pressing plate (210).

Also, the pouch-shaped secondary battery pressing jig according to the embodiment of the present invention may further include a controller configured to determine whether the pouch-shaped secondary battery (10) is defective based on the insulation resistance measured by the measurement unit (400).

In addition, a pouch-shaped secondary battery inspection method using the pouch-shaped secondary battery pressing jig according to the embodiment of the present invention includes (S1) disposing a pouch-shaped secondary battery on the first pressing plate, (S2) moving the second pressing plate in the second direction to press the pouch-shaped secondary battery, (S3) measuring the insulation resistance of the pouch-shaped secondary battery through the measurement unit, and (S4) moving the second pressing plate in the first direction to release pressing of the pouch-shaped secondary battery.

Also, in the pouch-shaped secondary battery inspection method according to the embodiment of the present invention, in step (S3), the controller may determine whether the pouch-shaped secondary battery (10) is defective based on an insulation resistance value of the pouch-shaped secondary battery (10) measured through the measurement unit (400).

Also, in the pouch-shaped secondary battery inspection method according to the embodiment of the present invention, in step (S4), the air injection unit (300) may inject air to the first surface (11) of the pouch-shaped secondary battery (10) through the air hole (213).

### [Advantageous Effects]

As is apparent from the above description, in a pouch-shaped secondary battery pressing jig according to the present invention and a pouch-shaped secondary battery inspection method using the same, an air injection unit injects air to a first surface of a pouch-shaped secondary battery through an air hole formed in a second pressing plate, whereby it is possible to prevent the occurrence of surface pressure and pickup errors for the pouch-shaped secondary battery.

### [Description of Drawings]

FIG. 1 is a view illustrating a conventional pouch-shaped secondary battery pressing jig.
FIG. 2 is a perspective view illustrating a pouch-shaped secondary battery pressing jig according to an embodiment of the present invention.
FIG. 3 is a view illustrating a first pressing unit and a second pressing unit of the pouch-shaped secondary battery pressing jig according to the embodiment of the present invention.
FIG. 4 is a view illustrating that the first pressing unit and the second pressing unit of the pouch-shaped secondary battery pressing jig according to the embodiment of the present invention press a pouch-shaped secondary battery.
FIG. 5 is a perspective view illustrating a second pressing plate of the pouch-shaped secondary battery pressing jig according to the embodiment of the present invention.
FIG. 6 is a sectional view illustrating the second pressing plate shown in FIG. 5.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

In addition, the same reference numbers will be used throughout the drawings to refer to parts that perform similar functions or operations. In the case in which one part is said to be connected to another part throughout the specification, not only may the one part be directly connected to the other part, but also, the one part may be indirectly connected to the other part via a further part. In addition, that a predetermined element is included does not mean that other elements are excluded, but means that such elements may be further included unless mentioned otherwise.

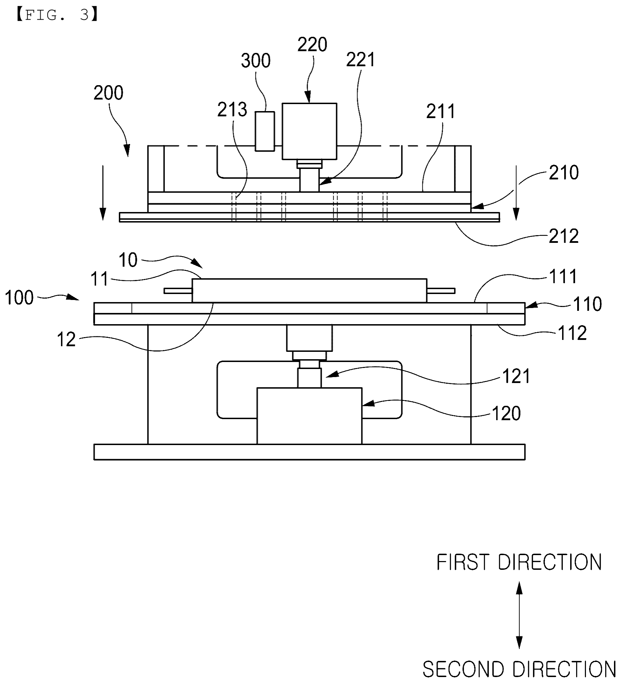

In addition, based on FIG. 3, a first direction is a 12 o'clock direction, and a second direction is a 6 o'clock direction.

Hereinafter, a pouch-shaped secondary battery pressing jig according to the present invention will be described.

First, a pouch-shaped secondary battery 10 includes a battery case, wherein the battery case is made of a laminate sheet including an inner covering layer, a metal layer, and an outer covering layer, and an electrode assembly and a gas pocket portion are formed in the battery case.

The inner covering layer is in direct contact with an electrode assembly, and therefore the inner covering layer must exhibit high insulation properties and high electrolytic resistance. In addition, the inner covering layer must exhibit high sealability in order to hermetically isolate the battery case from the outside, i.e., a thermally-bonded sealed portion between inner layers must exhibit excellent thermal bonding strength.

The inner covering layer may be made of a material selected from among a polyolefin-based resin, such as polypropylene, polyethylene, polyethylene acrylic acid, or polybutylene, a polyurethane resin, and a polyimide resin, which exhibit excellent chemical resistance and high sealability; however, the present invention is not limited thereto, and polypropylene, which exhibits excellent mechanical properties, such as tensile strength, rigidity, surface hardness, and impact resistance, and excellent chemical resistance, is the most preferably used.

The metal layer, which abuts the inner covering layer, corresponds to a barrier layer configured to prevent moisture or various gases from permeating into the battery from the outside. An aluminum thin film, which is lightweight and easily shapeable, may be used as a preferred material for the metal layer.

The outer covering layer is provided at the other surface of the metal layer, and the outer covering layer may be made of a heat-resistant polymer that exhibits excellent tensile strength, resistance to moisture permeation, and resistance to air transmission such that the outer covering layer exhibits high heat resistance and chemical resistance while protecting the electrode assembly. As an example, the outer covering layer may be made of nylon or polyethylene terephthalate; however, the present invention is not limited thereto.

The electrode assembly may be a jelly-roll type electrode assembly, which is configured to have a structure in which a long sheet type negative electrode and a long sheet type positive electrode are wound in the state in which a separator is interposed therebetween, a stacked type electrode assembly including unit cells, each of which is configured to have a structure in which a rectangular positive electrode and a rectangular negative electrode are stacked in the state in which a separator is interposed therebetween, a stacked and folded type electrode assembly, which is configured to have a structure in which unit cells are wound using a long separation film, or a laminated and stacked type electrode assembly, which is configured to have a structure in which unit cells are stacked in the state in which a separator is interposed therebetween and are then attached to each other; however, the present invention is not limited thereto.

The positive electrode includes a positive electrode current collector and a positive electrode active material applied to each of an upper surface and a lower surface of the positive electrode current collector.

In general, the positive electrode current collector may have a thickness of 3 to 500 µm. The positive electrode current collector is not particularly restricted as long as the positive electrode current collector exhibits high conductivity while the positive electrode current collector does not induce any chemical change in a battery. For example, the positive electrode current collector may be made of stainless steel, aluminum, nickel, titanium, or sintered carbon. Alternatively, the positive electrode current collector may be made of aluminum or stainless steel, the surface of which is treated with carbon, nickel, titanium, or silver. In addition, the positive electrode current collector may have a micro-scale uneven pattern formed on the surface thereof so as to increase adhesion of the positive electrode active material, or may be configured in any of various forms, such as a film, a sheet, a foil, a net, a porous body, a foam body, and a non-woven fabric body.

Meanwhile, the positive electrode active material may be mixed with a conductive agent and a binder, and a filler may be further added if necessary.

The negative electrode includes a negative electrode current collector and a negative electrode active material applied to each of an upper surface and a lower surface of the negative electrode current collector.

The negative electrode current collector is generally manufactured so as to have a thickness of 3 to 500 µm. The negative electrode current collector is not particularly restricted as long as the negative electrode current collector exhibits high conductivity while the negative electrode current collector does not induce any chemical change in a battery to which the negative electrode current collector is applied. For example, the negative electrode current collector may be made of copper, stainless steel, aluminum, nickel, titanium, or sintered carbon. Alternatively, the negative electrode current collector may be made of copper or stainless steel, the surface of which is treated with carbon, nickel, titanium, or silver, or an aluminum-cadmium alloy.

In addition, the negative electrode current collector may have a micro-scale uneven pattern formed on the surface thereof so as to increase adhesion of the negative electrode active material, or may be configured in any of various forms, such as a film, a sheet, a foil, a net, a porous body, a foam body, and a non-woven fabric body.

Of course, the negative electrode active material may be further mixed with a conductive agent and a binder, and the negative electrode current collector may be coated with the mixture.

The separator prevents short circuit between the negative electrode and the positive electrode and allows only migration of lithium ions. It is preferable for the separator to be made of any one selected from among polyethylene, polypropylene, a dual layer of polyethylene/polypropylene, a triple layer of polyethylene/polypropylene/polyethylene, a triple layer of polypropylene/polyethylene/polypropylene, and organic fiber filter paper; however, the present invention is not limited thereto.

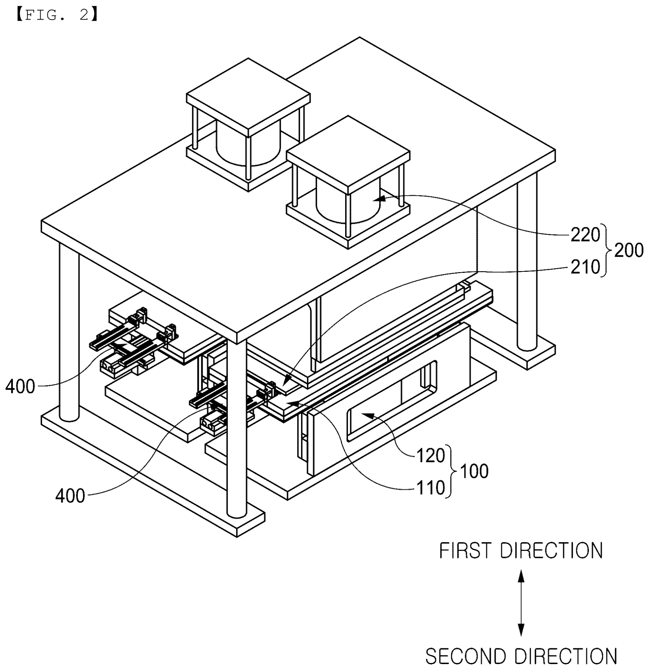

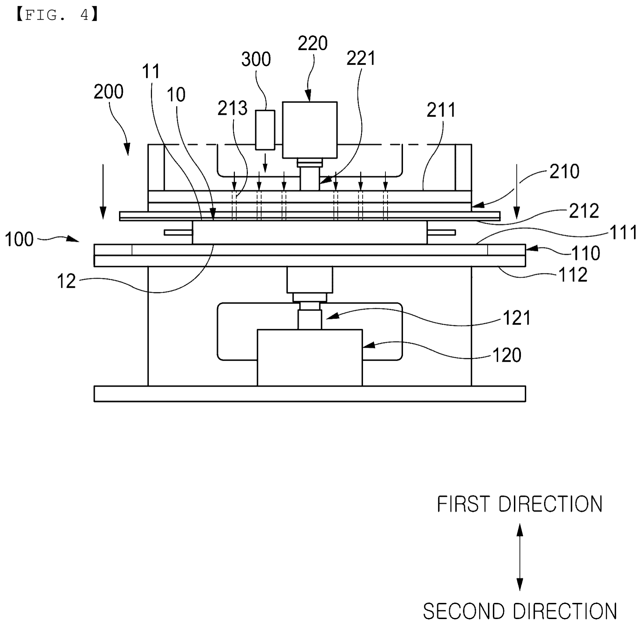

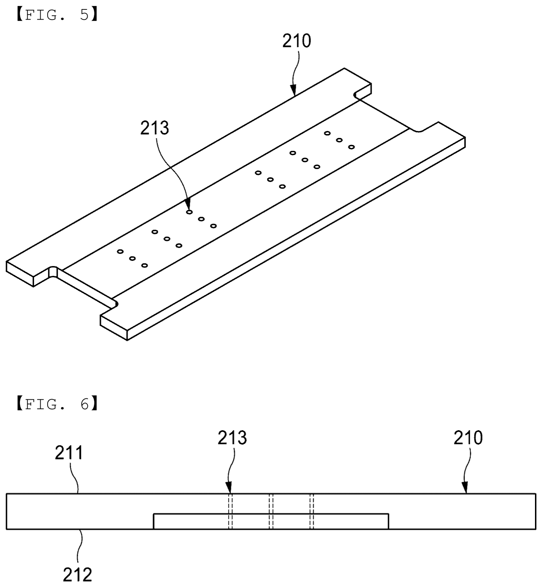

FIG. 2 is a perspective view illustrating a pouch-shaped secondary battery pressing jig according to an embodiment of the present invention, FIG. 3 is a view illustrating a first pressing unit and a second pressing unit of the pouch-shaped secondary battery pressing jig according to the embodiment of the present invention, and FIG. 4 is a view illustrating that the first pressing unit and the second pressing unit of the pouch-shaped secondary battery pressing jig according to the embodiment of the present invention press a pouch-shaped secondary battery. In addition, FIG. 5 is a perspective view illustrating a second pressing plate of the pouch-shaped secondary battery pressing jig according to the embodiment of the present invention, and FIG. 6 is a sectional view illustrating the second pressing plate shown in FIG. 5.

Referring to FIGs. 2 to 6, the pouch-shaped secondary battery pressing jig according to the present invention includes a first pressing unit 100, a second pressing unit 200, an air injection unit 300, a measurement unit 400, and a controller (not shown).

First, the first pressing unit 100 may include a first pressing plate 110, a first driving unit 120, and a pressing sensor 130.

The first pressing plate 110 may be configured to allow the second surface 12 of a pouch-shaped secondary battery 10 to be seated thereon. For example, based on FIG. 3, the second surface 12 of the pouch-shaped secondary battery 10 may be a lower surface of the pouch-shaped secondary battery 10, and the first pressing plate 110 may be provided to be located on the side of the pouch-shaped secondary battery 10 in the second direction.

In addition, the first pressing plate 110 may include a third surface 111 located in the first direction and a fourth surface 112 located in the second direction. The third surface 111 of the first pressing plate 110 may be in contact with the second surface 12 of the pouch-shaped secondary battery 10. In addition, a shaft 121 of the first driving unit 120 may be connected to the fourth surface 112 of the first pressing plate 110.

The first driving unit 120 is connected to the fourth surface 112 of the first pressing plate 110 via the shaft 121, may support the first pressing plate 110, and may move the first pressing plate 110 in the first direction.

For example, the first driving unit 120 may be configured to support the pouch-shaped secondary battery 10 or to back the same up in response to the force applied in the second direction when the force in the second direction is applied thereto by the second pressing unit 200. For example, the first driving unit 120 may be a backup cylinder.

In addition, the pressing sensor 130 may be configured to measure the force applied in the second direction when the force applied in the second direction is provided to the pouch-shaped secondary battery 10 by the second pressing unit 200. The pressing sensor 130 may be a press load cell.

In this case, the first driving unit 120 may provide the force applied in the first direction to the second surface 12 of the pouch-shaped secondary battery 10 in response to the force applied in the second direction measured by the pressing sensor 130.

The second pressing unit 200 may include a second pressing plate 210 and a second driving unit 220. The second pressing plate 210 may be in contact with a first surface 11 of the pouch-shaped secondary battery 10. For example, based on FIG. 3, the first surface 11 of the pouch-shaped secondary battery 10 may be an upper surface of the pouch-shaped secondary battery 10, and the second pressing plate 210 may be located on the side of the pouch-shaped secondary battery 10 in the first direction.

In addition, the second pressing plate 210 may be spaced apart from the first pressing plate 110 in the first direction. That is, the second pressing plate 210 and the first pressing plate 110 may be spaced apart from each other, and the pouch-shaped secondary battery 10 may be disposed in gap formed between the first pressing plate 110 and the second pressing plate 210.

The second pressing plate 210 may include a fifth surface 211 located in the first direction and a sixth surface 212 located in the second direction. The sixth surface 212 of the second pressing plate 210 may be in contact with the first surface 11 of the pouch-shaped secondary battery 10. In addition, a shaft 221 of the second driving unit 220 may be connected to the fifth surface 211 of the second pressing plate 210.

In addition, the sixth surface 212 of the second pressing plate 210 may be a plate configured to check whether the first surface 11 of the pouch-shaped secondary battery 10 is electrically conducted, wherein the plate may include Cu (or brass).

The second pressing plate 210 may be provided with an air hole 213 formed so as to allow the fifth surface 211 and the sixth surface 212 to communicate with each other. A plurality of air holes 213 may be formed in a central part of the second pressing plate 210 in contact with the first surface 11 of the pouch-shaped secondary battery 10. For example, the plurality of air holes 213 may be disposed over the width or length corresponding to the size of the first surface 11 of the pouch-shaped secondary battery 10.

The shaft 221 of the second driving unit 220 of the second pressing unit 200 may be connected to the fifth surface 211 of the second pressing plate 210, and may move the second pressing plate 210 in the second direction. At this time, the second driving unit 220 may move the second pressing plate 210 in the second direction, and may provide the force applied in the second direction to the first surface 11 of the pouch-shaped secondary battery 10.

Accordingly, the second pressing unit 200 may press the first surface 11 of the pouch-shaped secondary battery 10 through the second pressing unit 220.

The second pressing unit 200 may press the pouch-shaped secondary battery 10 as the second driving unit 220 moves the second pressing plate 210 in the second direction, and the first driving unit 110 of the first pressing unit 100 may provide the force applied in the first direction in response to the force applied in the second direction provided by the second pressing unit 200. The first pressing unit 100 and the second pressing unit 200 may press the pouch-shaped secondary battery 10 in the first direction and the second direction.

Meanwhile, the air injection unit 300 may be configured to inject air to the first surface 11 of the pouch-shaped secondary battery 10 through the air hole 213 formed in the second pressing plate 210.

The air injection unit 300 may be located on the side of the second pressing plate 210 in the first direction. In other words, the air injection unit 300 may be located on the side of the second pressing plate 210 in the first direction, wherein a nozzle configured to inject air is disposed toward the air hole 213 so as to inject air in the second direction.

In addition, when the first surface 11 of the pouch-shaped secondary battery 10 is attached to the sixth surface 212 of the second pressing plate 210, the air injection unit 300 may inject air to the first surface 11 of the pouch-shaped secondary battery 10 to separate the pouch-shaped secondary battery 10 from the second pressing plate 210.

For example, that a pouch-shaped secondary battery 10 is separated from the second pressing plate 210 may mean that, when the second pressing unit 200 presses the pouch-shaped secondary battery 10 and moves the second pressing plate 210 in the first direction, the air injection unit 300 injects air to the first surface 11 of the pouch-shaped secondary battery 10 and then the second pressing plate 210 is moved in the first direction to separate the pouch-shaped secondary battery 10 from the second pressing plate 210.

The air injection unit 300 and the air hole 213 may prevent the occurrence of surface pressure and pickup errors for the pouch-shaped secondary battery 10.

The measurement unit 400 may be configured to measure the insulation resistance between the pouch-shaped secondary battery 10 and the first pressing plate 110 or the second pressing plate 210. For example, the measurement unit 400 may measure the insulation resistance between the first pressing plate 110 or the second pressing plate 210 and the pouch-shaped secondary battery 10 through contact between the first pressing plate 110 or the second pressing plate 210 and both leads of the pouch-shaped secondary battery 10 via an electrical conduction rubber.

A method of measuring the insulation resistance of the pouch-shaped secondary battery 10 using the measurement unit 400 is a commonly known method capable of measuring the insulation resistance, and therefore a more detailed description thereof will be omitted.

In addition, the controller (not shown) may be configured to determine whether the pouch-shaped secondary battery 10 is defective based on the insulation resistance measured by the measurement unit 400. For example, the controller (not shown) may determine whether the pouch-shaped secondary battery 10 is defective by measuring the insulation of the pouch-shaped secondary battery 10 based on the resistance between the pouch-shaped secondary battery 10 and the first pressing plate 110 or the second pressing plate 210 measured by the measurement unit 400.

For example, the controller (not shown) may determine whether the pouch-shaped secondary battery 10 is defective by presetting a reference value for resistance, current, or voltage and comparing the resistance, current, or voltage measured by the measurement unit 400 with the preset reference value.

A method of the controller (not shown) determining whether the pouch-shaped secondary battery is defective may be implemented by any of various methods that are obvious to those skill in the art, and therefore a more detailed description thereof will be omitted.

The controller (not shown) may be implemented in the form of hardware, in the form of software, or in a combined form of hardware and software. The controller may be implemented in the form of a computing device (an arithmetic device) such as a microprocessor, but is not limited thereto, and may be implemented in any of various forms that are obvious to those skilled in the art.

Here, a pouch-shaped secondary battery inspection method using the pouch-shaped secondary battery pressing jig according to the embodiment of the present invention will be described with reference to FIGs. 2 to 6.

The pouch-shaped secondary battery inspection method according to the present invention includes the steps of (S1) disposing a pouch-shaped secondary battery 10 on the first pressing plate 110, (S2) moving the second pressing plate 210 in the second direction to press the pouch-shaped secondary battery 10, (S3) measuring the insulation resistance of the pouch-shaped secondary battery 10 through the measurement unit 400, and (S4) moving the second pressing plate 210 in the first direction to release pressing of the pouch-shaped secondary battery 10.

For example, in step (S1), the pouch-shaped secondary battery 10 may be seated on the third surface 111 of the first pressing plate 110.

In addition, in step (S3), the controller (not shown) may determine whether the pouch-shaped secondary battery 10 is defective based on the insulation resistance value of the pouch-shaped secondary battery 10 measured through the measurement unit 400. For example, in step (S3), the controller (not shown) may compare the insulation resistance of the pouch-shaped secondary battery 10 measured by the measurement unit 400 with a preset reference value, and may determine that the pouch-shaped secondary battery 10 is defective if the insulation resistance of the pouch-shaped secondary battery 10 is less than the preset reference value.

In addition, the insulation resistance value of the pouch-shaped secondary battery 10 may be measured in advance before step (S1) and may be compared with and the insulation resistance value of the pouch-shaped secondary battery 10 measured in step (S3) to determine whether the pouch-shaped secondary battery 10 is defective.

In step (S4), the air injection unit 300 may inject air to the first surface 11 of the pouch-shaped secondary battery 10 through the air hole 213. For example, when the second pressing plate 210 is moved in the first direction, the air injection unit 300 may inject air to the first surface 11 of the pouch-shaped secondary battery 10 to prevent pickup errors due to movement of the pouch-shaped secondary battery 10 in the state in which the first surface 11 of the pouch-shaped secondary battery 10 is attached to the sixth surface 212 of the second pressing plate 210.

Although the specific details of the present invention have been described in detail, those skilled in the art will appreciate that the detailed description thereof discloses only preferred embodiments of the present invention and thus does not limit the scope of the present invention. Accordingly, those skilled in the art will appreciate that various changes and modifications are possible, without departing from the category and the technical idea of the present invention, and it will be obvious that such changes and modifications fall within the scope of the appended claims.

### (Description of Reference Numerals)

10: Pouch-shaped secondary battery
11: First surface 12: Second surface
100: First pressing unit
110: First pressing plate
111: Third surface 112: Fourth surface
120: First driving unit 121: Shaft of first driving unit
200: Second pressing unit
210: Second pressing plate
211: Fifth surface 212: Sixth surface
213: Air hole
220: Second driving unit 221: Shaft of second driving unit
300: Air injection unit
400: Measurement unit

## Claims

1. A pouch-shaped secondary battery pressing jig comprising:
a first pressing unit comprising a first pressing plate configured to seat a second surface of a pouch-shaped secondary battery thereon;
a second pressing unit comprising a second pressing plate having an air hole configured to allow a fifth surface and a sixth surface to communicate with each other, the second pressing unit being configured to press a first surface of the pouch-shaped secondary battery; and
an air injection unit configured to inject air to the first surface of the pouch-shaped secondary battery through the air hole.

2. The pouch-shaped secondary battery pressing jig according to claim 1, wherein the first pressing unit comprises:
the first pressing plate comprising a third surface in contact with the second surface of the pouch-shaped secondary battery; and
a first driving unit having a shaft connected to a fourth surface of the first pressing plate and configured to support the first pressing plate, the first driving unit being configured to move the first pressing plate in a first direction.

3. The pouch-shaped secondary battery pressing jig according to claim 2, wherein the first pressing unit further comprises a pressing sensor configured to measure force applied in a second direction when the force applied in the second direction is transmitted to the pouch-shaped secondary battery by the second pressing unit.

4. The pouch-shaped secondary battery pressing jig according to claim 3, wherein the first driving unit is configured to apply force in the first direction to the second surface of the pouch-shaped secondary battery in response to the force applied in the second direction measured by the pressing sensor.

5. The pouch-shaped secondary battery pressing jig according to claim 1, wherein the second pressing unit comprises:
the second pressing plate in contact with the first surface of the pouch-shaped secondary battery; and
a second driving unit having a shaft connected to the fifth surface of the second pressing plate, the second driving unit being configured to move the second pressing plate in a second direction.

6. The pouch-shaped secondary battery pressing jig according to claim 4, wherein the second driving unit is configured to move the second pressing plate in the second direction and provide the force applied in the second direction to the first surface of the pouch-shaped secondary battery.

7. The pouch-shaped secondary battery pressing jig according to claim 1, wherein the second pressing plate is disposed spaced apart from the first pressing plate in a first direction.

8. The pouch-shaped secondary battery pressing jig according to claim 1, wherein the air hole is a plurality of air holes in a central part of the second pressing plate in contact with the first surface of the pouch-shaped secondary battery.

9. The pouch-shaped secondary battery pressing jig according to claim 8, wherein, when the first surface of the pouch-shaped secondary battery is attached to the second pressing plate, the air injection unit is configured to inject air to the first surface of the pouch-shaped secondary battery to separate the pouch-shaped secondary battery from the second pressing plate.

10. The pouch-shaped secondary battery pressing jig according to claim 1, comprising a measurement unit configured to measure insulation resistance between the pouch-shaped secondary battery and the first pressing plate or the second pressing plate.

11. The pouch-shaped secondary battery pressing jig according to claim 10, further comprising a controller configured to determine whether the pouch-shaped secondary battery is defective based on the insulation resistance measured by the measurement unit.

12. A pouch-shaped secondary battery inspection method using the pouch-shaped secondary battery pressing jig according to any one of claims 1 to 11, the pouch-shaped secondary battery inspection method comprising:
(S1) disposing a pouch-shaped secondary battery on the first pressing plate;
(S2) moving the second pressing plate in the second direction to press the pouch-shaped secondary battery;
(S3) measuring insulation resistance of the pouch-shaped secondary battery through the measurement unit; and
(S4) moving the second pressing plate in the first direction to release pressing of the pouch-shaped secondary battery.

13. The pouch-shaped secondary battery inspection method according to claim 12, wherein, in step (S3), the controller determines whether the pouch-shaped secondary battery is defective based on an insulation resistance value of the pouch-shaped secondary battery measured through the measurement unit.

14. The pouch-shaped secondary battery inspection method according to claim 12, wherein, in step (S4), the air injection unit injects air to the first surface of the pouch-shaped secondary battery through the air hole.
